## Europäisches Patentamt
## European Patent Office
## Office européen des brevets

(11) Publication number: **0 066 280**
**B1**

(12) **EUROPEAN PATENT SPECIFICATION**

(45) Date of publication of patent specification: **02.03.88**

(21) Application number: **82104717.2**

(22) Date of filing: **28.05.82**

(51) Int. Cl.⁴: **H 01 L 21/00**

(54) Method for manufacturing semiconductor device.

(30) Priority: **02.06.81 JP 84599/81**

(43) Date of publication of application:
**08.12.82 Bulletin 82/49**

(45) Publication of the grant of the patent:
**02.03.88 Bulletin 88/09**

(84) Designated Contracting States:
**DE FR GB NL**

(56) References cited:
**EP-A-0 010 596**
**EP-A-0 010 624**

(73) Proprietor: **Kabushiki Kaisha Toshiba
72, Horikawa-cho Saiwai-ku
Kawasaki-shi Kanagawa-ken 210 (JP)**

(72) Inventor: **Sasaki, Yoshitaka
1428-3, Nakata-cho Totsuka-ku
Yokohama-shi (JP)**
Inventor: **Kanzaki, Koichi
4-205, Miyamaedaira-Aberiya 2-10-1,
Miyamaedaira
Takatsu-ku Kawasaki-shi (JP)**

(74) Representative: **Blumbach Weser Bergen
Kramer Zwirner Hoffmann Patentanwälte
Radeckestrasse 43
D-8000 München 60 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method for manufacturing a semiconductor device of finer pattern and improved performance.

Semiconductor devices, especially, semiconductor integrated circuits have been highly developed by the fine patterning technique such as photoetching, the ion-implantation technique, other dryetching techniques and the like. Even if the element size is proportionally reduced, integration density of the devices cannot be increased greatly according to the conventional method due to restrictions imposed by the contact hole formation technique or need for alignment margins. In order to solve this problem, a method called SELOCOS is proposed by Sunami et al. (J.J.A.P. 18, 1979, PP. 255—260). According to this method, contact holes are formed by self alignment. When an $n^-$-type polycrystalline silicon layer of high concentration and a silicon substrate (impurity concentration: $10^{15}$ to $10^{16}$ $cm^{-3}$) are oxidized at a low temperature of 700°C, an oxide film is formed on the $n^-$-type polycrystalline silicon layer to a thickness of several times to several tens times the thickness thereof on the silicon substrate. By utilizing this thickness difference, only the thin oxide film is etched to form self-aligned contact holes. However, the quality of the oxide film formed on the $n^+$-type polycrystalline silicon layer is significantly worse than a conventional thermal oxide film which is formed on a silicon substrate of an impurity concentration of $10^{15}$—$10^{16}$ $cm^{-3}$ at a temperature of 1,000°C. For example, the breakdown voltage of the conventional thermal oxide film having a thickness of 1,000 Å is 80 to 90 V/cm, while that of the oxide film having a thickness of 2,000 Å on the $n^+$-type polycrystalline silicon film is 10 to 20 V/cm. Further, the oxide film on the $n^+$-type polycrystalline silicon layer is not resistant to etchants such as fluoric acid. Therefore, a good insulating property may often be impaired.

In order to solve the above problems, a method using dry etching, especially, RIE (reactive ion etching) which substantially eliminates undercutting is proposed to form self-aligned contact holes. According to this method, a multi-layer pattern comprising an $n^+$-type polycrystalline silicon film, a CVD oxide film, and a nitride film is formed on a silicon substrate. The wafer is then wet-oxidized at a temperature of 800°C. As a result, an oxide film of 3,500 Å thickness is formed on the side surfaces of the $n^+$-type polycrystalline silicon layer, while a thin oxide film of 400 Å thickness is formed on the silicon substrate. The thin oxide film is etched by RIE using a Freon gas. According to RIE, a film is generally etched by bombarding accelerated reactive ions, decreasing side etching extremely. The nitride film of the multi-layer pattern has an overhang structure. The overhang nitride film is used as a mask when etching is performed. Therefore, the oxide film formed on the side surfaces of the $n^+$-type polycrystalline silicon layer is not substantially etched. Further, the oxide film formed on the substrate and located immediately below the overhang of the nitride film is not etched. This oxide film serves to improve insulation between the silicon substrate and the $n^+$-type polycrystalline silicon layer.

Although RIE has the above advantages, the silicon substrate is damaged when the contact holes are formed, resulting in degradation in electrical characteristics of the element. The damage can hardly be eliminated by a thermal treatment or etching using an alkali (KOH) solution to be performed in the subsequent step. Conventionally, the damage which occurs in a region of 100 to 200 Å depth from the surface is etched by an alkali solution. However, since a material constituting electrodes and inner walls of an RIE apparatus, a deposit (heavy metal) on the inner walls, and a polymer produced during RIE are attached to the surface of the silicon substrate, the damage due to etching cannot be substantially eliminated. The damage in the surface layer of the silicon substrate causes the OSF (oxidation induced stacking fault) and flow of a leakage current between semiconductor regions, and increases a contact resistance.

The following method is proposed to eliminate contamination of the silicon substrate surface with the polymer or heavy metal. The silicon substrate (contact hole) exposed by RIE is treated in an oxygen plasma atmosphere and dipped in a diluted fluoric acid. By repeating the above process, a polymer film on the surface of the silicon substrate is completely eliminated. Thereafter, the damage in the surface layer is eliminated by isotropic etching such as dry etching and wet etching using an alkali solution.

When the damage is eliminated according to the above process, the electrical characteristics of the element are improved greatly. However, since the above process which uses diluted fluoric acid is repeated a few or more times, the oxide film formed on the side surfaces of the $n^+$-type polycrystalline silicon is gradually etched. As a result, the $n^+$-type polycrystalline silicon may be exposed. If it is exposed, a short circuit is formed between the source and drain or between the gate and drain of a MOS type transistor through metallization. In order to eliminate short-circuiting, the silicon oxide formed by thermal oxidation on the side surfaces of the $n^+$-type polycrystalline silicon pattern is formed relatively thick. Since the $n^+$-type polycrystalline silicon pattern is thermally oxidized from its both side surfaces, it becomes narrower and its part having a step may often be cut off. Further, since the $n^+$-type polycrystalline silicon pattern is used as the gate electrode in the MOS type transistor, the gate width is changed by thermal oxidation, resulting in a change in a threshold voltage Vth.

The document EP—A—0 010 624 discloses a method for forming very small mask openings for the manufacturing of semiconductor devices. According to this known method a first insulating layer with horizontal and vertical surface portions is formed on a substrate. Then a second insulating layer is formed above the first insulating layer and the substrate, the second insulating layer being of a material different from that of the first insulating layer. The second insulating layer is etched by reactive ion-etching such that the horizontal portions of the second insulating layer are removed and that only very small regions of the second insulating layer on the vertically directed surface portions of the first insulating layer remain. After that the exposed substrate regions are thermically oxidized. Then the remaining regions of the second insulating layer are removed to thus form the desired mask openings.

It is an object of the present invention to provide a method for manufacturing a semiconductor device to achieve micronization of a semiconductor element and to improve electrical characteristics of the element greatly. This object is achieved with a method as claimed in claim 1.

Specific embodiments of the invention are claimed in the dependent claims.

This invention can be more fully understood from the following detailed description when taken in conjunction with the accompanying drawings, in which:

Figs. 1A to 1F are sectional views showing the steps for manufacturing an n-channel MOS type semiconductor in Example 1 according to the present invention;

Figs. 2A to 2C are sectional views illustrating the steps for manufacturing an n-channel MOS type semiconductor in Example 2 according to the present invention;

Figs. 3A to 3E are sectional views showing the steps for manufacturing an $I^2L$ including an SIT in Example 3 according to the present invention;

Figs. 4A to 4E are sectional views showing the steps for forming an npn-bipolar transistor in Example 4 according to the present invention;

Fig. 5 is a plan view of the npn-bipolar transistor shown in Fig. 4E;

Fig. 6 is a sectional view of the npn-bipolar transistor when taken along the line X—X of Fig. 5;

Figs. 7A to 7F are sectional views showing the steps for manufacturing an $I^2L$ in Example 5 according to the present invention;

Fig. 8 is a plan view of the $I^2L$ shown in Fig. 7F;

Fig. 9 is a sectional view of the $I^2L$ when taken along the line Y—Y in Fig. 8; and

Figs. 10A to 10F are sectional views showing the steps for manufacturing an n-channel MOS type semiconductor device in Example 6 according to the present invention.

A method for manufacturing a semiconductor device according to the present invention will be described with reference to the accompanying drawings.

A conductive material pattern covered with a first insulating film is formed on a semiconductor substrate according to the method of the present invention. If the conductive material pattern is applied to the manufacture of a MOS type semiconductor device, the conductive material pattern is formed on a substrate through an insulating layer such as an $SiO_2$ film. If the conductive material pattern is applied to the manufacture of a bipolar type semiconductor device or an SIT (static induction transistor), it is directly formed on a substrate. After the conductive material layer is formed on the entire surface of the substrate and an insulating material film is formed thereover, the insulating material film is patterned. The conductive material layer is then etched using the insulating layer as a mask. Impurity-doped polycrystalline silicon, impurity-doped amorphous silicon, refractory metal, metal silicide, Al, and an Al alloy can be used as the conductive material. Impurity-undoped polycrystalline silicon or amorphous silicon may be used as the starting material and doped with an impurity. Alternatively, impurity-undoped polycrystalline silicon or amorphous silicon may be converted to metal silicide. An $SiO_2$ film, an $Si_3N_4$ film or a laminate thereof may be used as the first insulating film.

A second insulating film is formed on the side surfaces of the conductive material pattern and the upper surface of the semiconductor substrate. The second insulating film may be deposited on the entire surface by the CVD method. Alternatively, a thick oxide film may be formed on the side surfaces of the conductive material pattern and a thin oxide film may be formed on the upper surface of the substrate, respectively, as the second insulating films by wet oxidation at a temperature of 900°C. In this method, since the second insulating film is not formed on part of the first insulating film on the conductive material pattern, a thick first insulating film must be formed so as not to allow etching of the first insulating film. Alternatively, a bi-layered structure having an oxide film and a nitride film may be used. With the latter method of forming the second insulating film by wet oxidation, since the contact holes can be formed by conventional wet etching, the silicon substrate is not damaged. However, the width of the conductive material pattern is slightly narrowed since side surfaces of the conductive material pattern are oxidized. Therefore, the former method of forming the second insulating film by CVD method is preferred from the view point of micronization of the device. In the former method, a CVD-$SiO_2$ film, a phosphorus-doped glass film, a boron-doped glass film, a silicon nitride film, or the like can be used as the second insulating film.

The masking material layer is then formed on the entire surface and serves as a mask for the second insulating film. The masking material layer comprises an undoped polycrystalline silicon film, a metal silicide film, a silicon nitride film, and an organic material film such as a photoresist film and must not be etched by an etchant for the second insulating film.

The masking material layer is then etched by anisotropic etching such as RIE. As a result, the masking material layer is removed except for the part thereof on the surface of the second insulating material formed on the side surfaces of the conductive material pattern.

The masking material pattern can then be used as part of the etching mask for forming a contact hole or as part of the mask for ion implantation of an impurity into the semiconductor substrate. By using this masking material pattern, a self-aligned contact hole or an impurity region can be formed.

According to the method of the present invention, the self-aligned contact hole or the impurity region can be formed in the process for manufacturing various devices such as an MOS-type semiconductor device, a bipolar-type semiconductor device and an SIT.

Elaborate patterning is performed according to the method of the present invention. Further, the threshold voltage of the device is increased greatly and the damage and contamination of the semiconductor substrate are prevented, thus providing an semiconductor device having a high packaging density and excellent electrical characteristics.

Various examples according to the present invention will be described in detail with reference to the accompanying drawings.

In Examples 1 to 3, a CVD-SiO$_2$ film is used as the second insulating film and polycrystalline silicon is used as the masking material. The method of the present invention is applied to manufacture MOS type semiconductor devices in Examples 1 and 2 and an I$^2$L including an SIT in Example 3.

### Example 1

(i) A p$^-$-type impurity layer 2 as a channel stopper was formed in a p-type silicon substrate. A field oxide film 3 was formed on the p$^+$-type impurity layer 2 and buried in the p-type silicon substrate 1. Thermal oxidation was performed to grow a silicon oxide film 4 of 400 to 1000 Å thickness as a gate oxide film. Thereafter, a p-type impurity, boron was then ion-implanted at a dose of about $5 \times 10^{11}$ cm$^{-2}$ in order to control the threshold voltage (Fig. 1A).

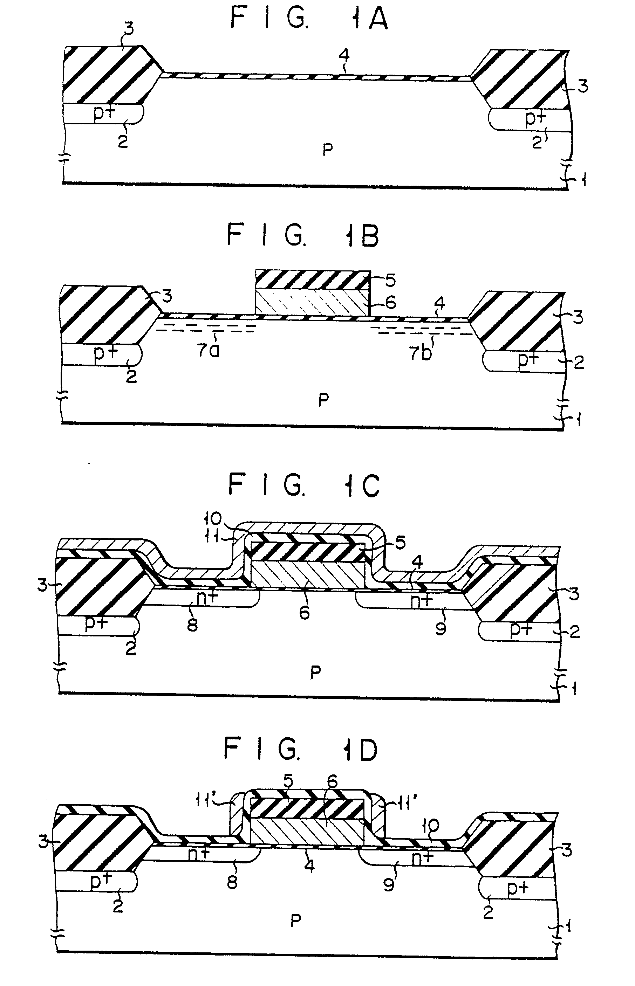

(ii) An arsenic-doped n$^+$-type polycrystalline silicon layer of 3,000 Å thickness and a CVD-SiO$_2$ film of 8,000 Å thickness were sequentially deposited on the silicon oxide film 4. The CVD-SiO$_2$ film was patterned by photoetching utilizing the RIE technique to form a CVD-SiO$_2$ film pattern 5 (first insulating film). The n$^+$-type polycrystalline silicon layer was then etched by RIE using the CVD-SiO$_2$ film pattern 5 as a mask to form a gate electrode 6. Arsenic was then ion-implanted in the p-type silicon substrate 1 through the silicon oxide film 4 using the CVD-SiO$_2$ film pattern 5 and the field oxide film 3 as masks to form arsenic-doped layers 7a and 7b (Fig. 1B). Alternatively, after the silicon oxide film 4 except for the part immediately under the gate electrode 6 may be removed, arsenic may be doped in the p-type silicon substrate 1.

(iii) Arsenic in the arsenic-doped layers 7a and 7b was activated and diffused by heat treatment in an oxygen atmosphere to form drain regions 8 and 9. After a CVD-SiO$_2$ film 10 (second insulating film) of 2,000 Å thickness was formed on the entire surface, a polycrystalline silicon layer 11 (masking material layer) of 3,000 Å thickness was deposited thereon (Fig. 1C). N$^+$-type source and drain regions may be formed by annealing in an oxygen atmosphere after arsenic was doped and the CVD-SiO$_2$ film was deposited. In this case, a very thin silicon oxide film is formed around the gate electrode 6 comprising the n$^+$-type polycrystalline silicon.

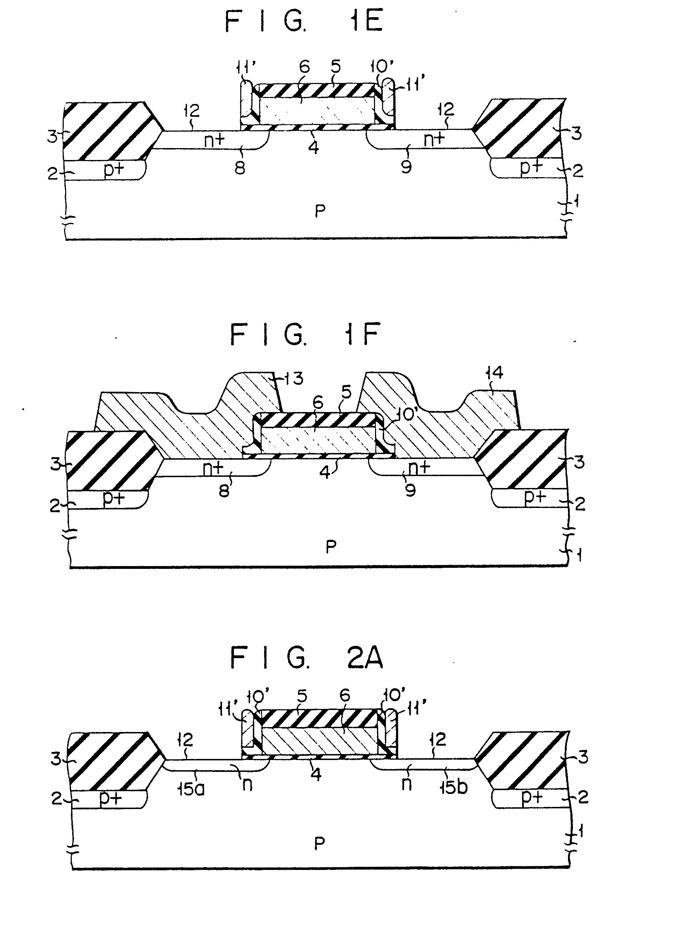

(iv) The polycrystalline silicon layer 11 was then etched by RIE using a CCl$_4$ type etchant. As shown in Fig. 1D, an undoped polycrystalline silicon film 11' (masking pattern) remained only on the surface part of the CVD-SiO$_2$ film 10 on the side surfaces of the gate electrode forming layer 6 and the CVD-SiO$_2$ film 5. Phosphorus gettering was then performed. The undoped polycrystalline silicon film 11' then became a residual n$^+$-type polycrystalline silicon film. RIE was then performed using the residual n$^+$-type polycrystalline silicon film as a mask and a Freon gas as an etchant. The CVD-SiO$_2$ film 10 and the silicon oxide film 4 were selectively etched only to form contact holes 12 of the source and drain. A CVD-SiO$_2$ film 10' remained on the side surfaces of the gate electrode forming layer 6 (Fig. 1E).

(v) After the residual n$^+$-type polycrystalline silicon film was removed, an electrode material film such as an Al film was vacuum-deposited on the entire surface. The electrode film was then patterned to form Al source and drain electrodes 13 and 14 connected to the source and drain regions 8 and 9 through the contact holes 12. Thus, an n-channel MOS type semi-conductor device was manufactured (Fig. 1F).

According to Example 1, a thermal oxide film for insulating the source and drain electrodes 13 and 14 need not be formed at the side surfaces of the gate electrode forming layer comprising the n$^+$-type polycrystalline silicon layer. The width of the gate electrode 6 may not be reduced to obtain the MOS type semiconductor device having a predetermined threshold voltage Vth. Further, since the shape of the gate electrode 6 formed by patterning the n$^+$-type polycrystalline silicon layer is maintained up to the final step, a gate electrode of 1 μm width can be formed. As a result, micronization of the element is accomplished and the threshold voltage Vth is improved greatly.

Since the duration of annealing can be shortened after the source and drain regions 8 and 9 are formed, these regions can be shallow. As a result, contact between the p$^+$-type impurity layer 2 and the source and drain regions 8 and 9 due to rediffusion of the impurity in the p$^+$-type impurity layer 2 is prevented to repress increase of the capacitance.

Further, since the upper and side surfaces of the gate electrode 6 comprising n$^+$-type polycrystalline silicon are covered with a residual CVD-SiO$_2$ film 10' and highly electrically resistive CVD-SiO$_2$ film pattern 5, sufficient passivation effects are achieved and the threshold voltage of the gate is much improved. The reproducibility in the process is also improved greatly. When the polycrystalline silicon layer 11 is etched to form the polycrystalline silicon layer 11' remaining on the CVD-SiO$_2$ film part corresponding to the side surfaces of the gate electrode 6 and the CVD-SiO$_2$ film pattern 5, the shape of the residual polycrystalline silicon layer 11' can be controlled by the thickness of the polycrystalline silicon layer 11. Since the CVD-SiO$_2$ film is etched by RIE using the residual n$^+$-type polycrystalline silicon layer 11' as a mask, its shape, that is, the lengths of the contact holes 12 of the source and drain can be determined by the thickness of the polycrystalline silicon layer 11. The gate electrode 6 is not exposed after etching by RIE, so that the electrical short-circuiting is properly prevented between the gate and the source or between the gate and the drain.

Example 2

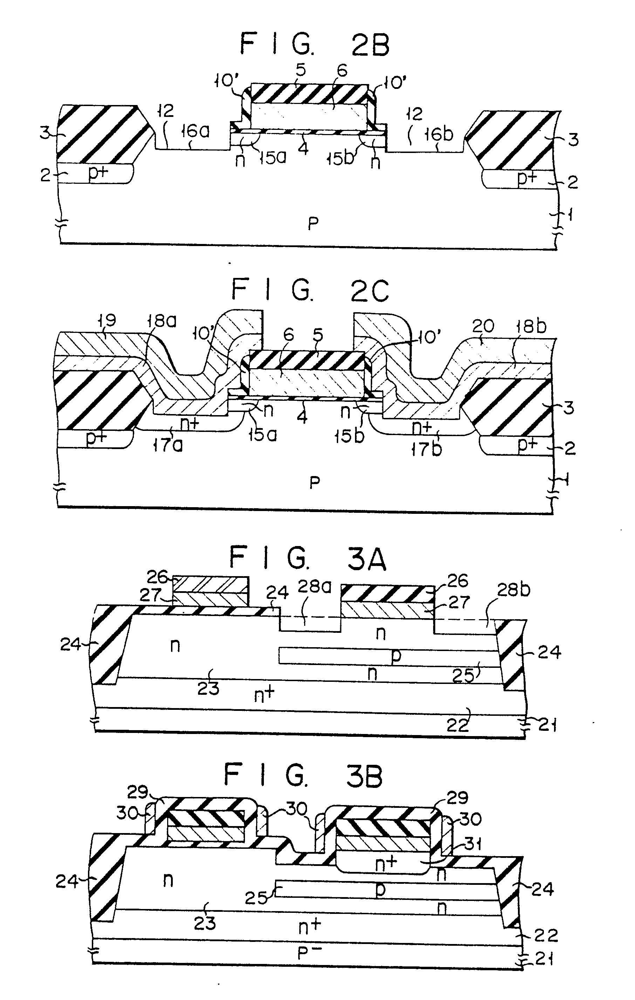

(i) The residual n$^+$-type polycrystalline silicon layer 11' was formed on the part of the CVD-SiO$_2$ film 10 on the side surfaces of the gate electrode 6 and the CVD-SiO$_2$ film pattern 5 according to steps (i) to (iv) in Example 1. RIE using a Freon gas was performed to form the contact holes 12 of the source and drain, using the residual n$^+$-type polycrystalline silicon layer 11' as a mask. Simultaneously, the CVD-SiO$_2$ film 10' remained on the side surfaces of the gate electrode 6 (Fig. 2A). In this step, n-type impurity regions 15a and 15b which were shallower than the source and drain regions in Example 1 were formed in the p-type silicon substrate 1. The residual n$^+$-type polycrystalline silicon layer 11' was etched subsequently. As shown in Fig. 2B, the residual n$^+$-type polycrystalline silicon layer 11' was removed and the n$^+$-type impurity regions 15a and 15b exposed in the contact holes 12 were mostly removed to form grooves 16a and 16b.

(ii) After an undoped polycrystalline layer was deposited, arsenic was ion-implanted on the entire surface. The CVD-SiO$_2$ film 5 on the gate electrode 6, the residual CVD-SiO$_2$ film 10' on the side surfaces of the gate electrode 6, and the field oxide film 3 served as masks and arsenic was doped in the silicon substrate 1 under the grooves 16a and 16b through the undoped polycrystalline silicon layer. Subsequently, annealing was performed to activate arsenic and form n$^+$-type impurity layers 17a and 17b. An Al film was vacuum-deposited on the entire surface and patterned to form Al source and drain electrodes 19 and 20. Using these electrodes 19 and 20 as masks, the arsenic-doped polycrystalline silicon layer was patterned to form arsenic-doped polycrystalline silicon patterns 18a and 18b under the source and drain electrods 19 and 20, respectively. Thus, an n-channel MOS type semiconductor device was manufactured (Fig. 2C).

According to Example 2, the source and drain regions can be formed by the n-type impurity layers 15a and 15b of a low impurity concentration which are located near the channel, and the n$^+$-type impurity layers 17a and 17b of a high impurity concentration which are in contact with the Al source and drain electrodes 19 and 20 through the polycrystalline patterns 18a and 18b. Therefore, the high-speed n-channel MOS type semiconductor device having a good ohmic contact is manufactured.

In Examples 1 and 2, the residual polycrystalline silicon layer 11' was etched by performing phosphor gettering in advance and by simultaneously converting it to the n$^+$-type polycrystalline silicon layer. Thus, by utilizing the etching rate difference, selective etching was performed. However, the polycrystalline silicon layer 11' may remain and metal electrodes such as Al electrodes may be deposited. In this case, the capacitance between the source and the gate or between the drain and the gate may be decreased by annealing the surface of the layer 11'.

Further, in Examples 1 and 2, the n$^+$-type polycrystalline silicon layer is deposited to form the gate electrode 6. However, the formation of the gate electrode is not limited to this. After the undoped polycrystalline silicon layer is formed, As or P may be ion-implanted or diffused.

Example 3

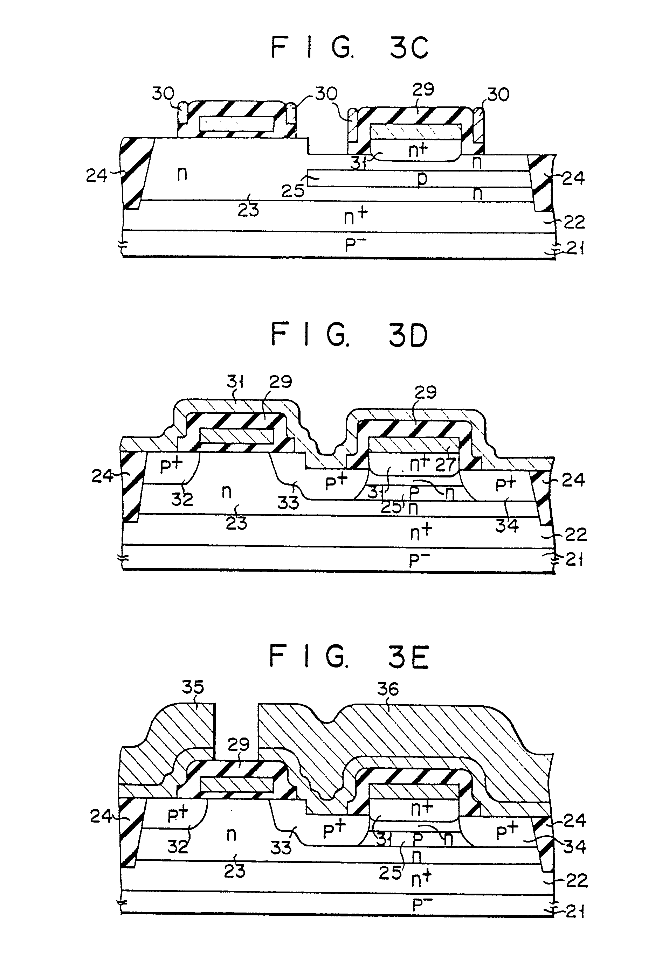

An n$^+$-type buried layer 22 and an n-type epitaxial layer 23 were formed on a p$^-$-type silicon substrate 21. An oxide film collar was then formed in the n$^+$-type buried layer 22 and the n-type epitaxial layer 23. Thereafter, the surface of the n-type epitaxial layer 23 was oxidized to form an oxide film of 1,500 Å thickness. This oxide film was then selectively etched to form an oxide film pattern 24. Boron (p-type impurity) of a low concentration was then selectively ion-implanted at a high acceleration voltage (180 keV) to form a p-type region 25 in the n-type epitaxial layer 23. A polycrystalline silicon layer which was doped with an n$^+$-type impurity and which had a thickness of 3,000 Å and a CVD-SiO$_2$ film of 3,000 Å thickness were sequentially deposited. The CVD-SiO$_2$ film was then etched by photoetching technique utilizing RIE to form a CVD-SiO$_2$ film pattern 26. Using this pattern 26 as a mask, the n$^+$-type polycrystalline silicon layer was etched to form a polycrystalline silicon layer pattern 27. Simutaneously, part of the surface layer of the n-type epitaxial layer 23 was etched to form grooves 28a and 28b (Fig. 3A).

A CVD-SiO$_2$ film 29 of 2,000 Å thickness was deposited to cover the entire surface and a polycrystalline silicon layer of 3,000 Å thickness was then deposited thereon. This polycrystalline silicon layer was then etched by RIE using a CCl$_4$ etchant. As a result, a polycrystalline layer pattern (masking pattern) 30 remained only on the surface of the CVD-SiO$_2$ film 29 on the side surfaces of the SiO$_2$ film pattern 26 and of the polycrystalline silicon layer pattern 27. Annealing was performed to diffuse the n-type impurity in the polycrystalline silicon pattern 27 to the n-type epitaxial layer 23. Thus, an n$^+$-type region was formed under the polycrystalline silicon pattern 27 (Fig. 3B).

Thereafter, using the residual polycrystalline silicon pattern 30 as the mask, the CVD-SiO$_2$ film 29 was etched by RIE using the Freon gas to form contact holes (Fig. 3C).

After the residual polycrystalline silicon pattern 30 was removed, a p$^+$-type polycrystalline silicon layer 31 doped with a p-type impurity, boron of a high concentration was deposited to cover the entire surface. Annealing was then performed to diffuse the p-type impurity into the n-type epitaxial layer to form p$^+$-type regions 32, 33 and 34 (Fig. 3D).

An Al film was deposited to cover the entire surface and patterned to form Al electrodes 35 and 36. Further, using the Al electrodes 35 and 36 as masks, the p$^+$-type polycrystalline silicon layer 31 was patterned. Thus, an I$^2$L including an SIT was manufactured (Fig. 3E).

Even if a photoresist film of about 3,000 Å was used instead of the polycrystalline silicon layer (masking material layer), the same semiconductor devices as obtained in Examples 1 to 3 were manufactured. The photoresist film was etched by RIE using an oxygen gas type etchant. The photoresist film pattern as the masking pattern was etched by dry etching using an oxygen gas etchant. Wet etching using a hot concentrated sulfuric acid or the like may be performed in place of dry etching.

In Examples 4 to 6 below, the thermal oxide film is used as the second insulating film and polycrystalline silicon is used as the masking material. The present invention is applied to Examples 4 and 6 for manufacture of MOS type semiconductor devices and to Example 5 for manufacture of an I$^2$L.

### Example 4

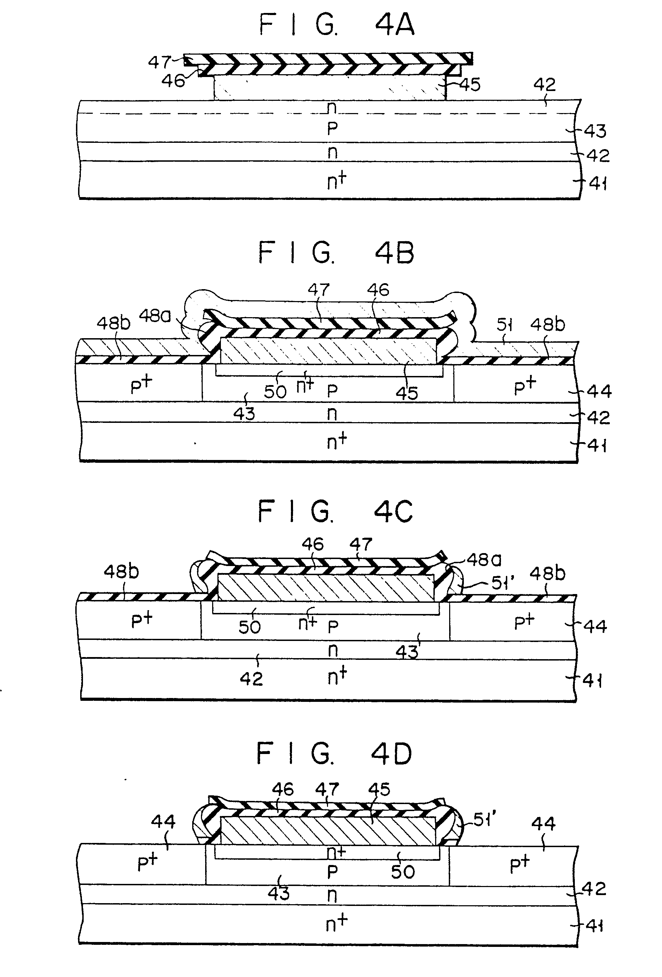

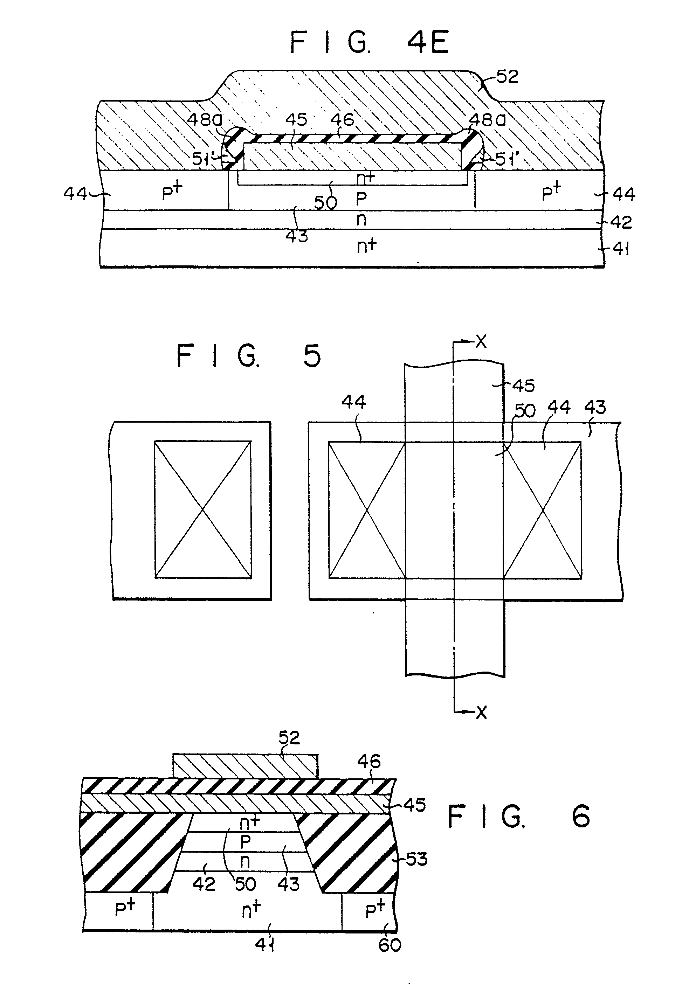

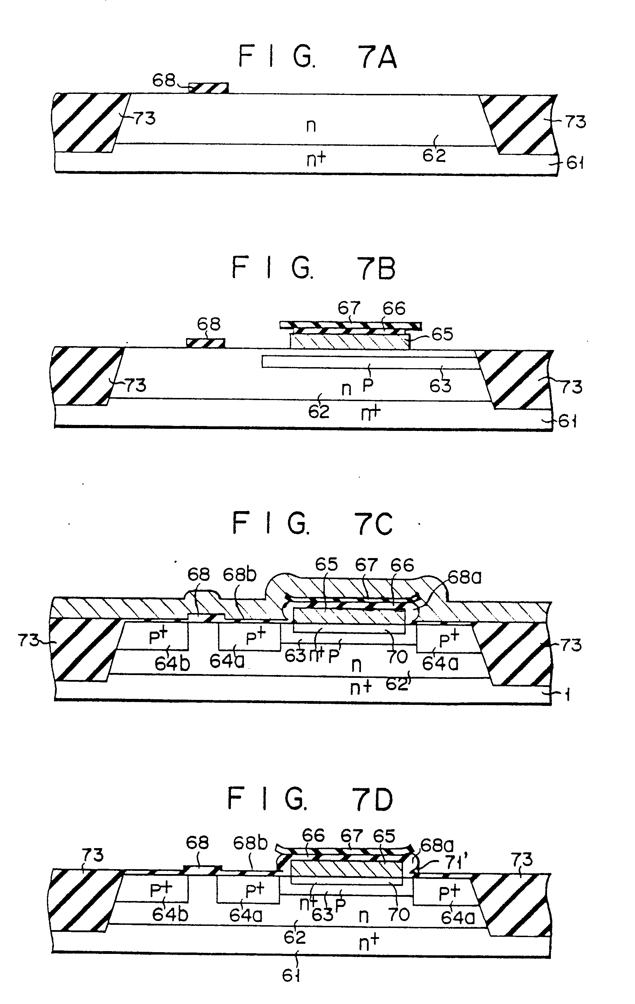

An n-type epitaxial layer 42 (silicon substrate) was grown on an n$^+$-type layer 41. Boron was ion-implanted in the n-type epitaxial layer 42 to form a p-type buried layer 43 (inner base). Subsequently, a conductive pattern comprising an arsenic-doped n$^-$-type polycrystalline silicon layer 45 of 2,000 Å thickness, a CVD-SiO$_2$ film 46 of 1,500 Å thickness, and a nitride film 47 of 1,500 Å thickness were formed on the silicon substrate 42 (Fig. 4A). Wet oxidation was performed at a temperature of 900°C to form thermal oxide films 48a and 48b of 3,500 Å thickness on the side surfaces of an n$^+$-type polycrystalline silicon pattern 45 and of 1,000 Å on the surface on the silicon substrate 42. The thin thermal oxide film 48a was formed thinner on parts of the side surfaces of the n$^+$-type polycrystalline silicon pattern 45 closer to the silicon substrate 42. The nitride film 47 and the thermal oxide film 48a constituted an overhang structure. Thermal oxidation was performed to diffuse the n$^+$-type impurity from the n$^+$-type polycrystalline silicon layer 45 to the p-type buried layer 43 so as to form an n$^+$-type layer 50. The p-type buried layer 43 was defined as the inner base layer, the n$^+$-type layer 50 was defined as an emitter layer, and the n$^+$-type polycrystalline silicon layer 45 was defined as an emitter electrode. A p$^+$-type impurity was ion-implanted to a high concentration and annealing was then performed to form a p$^+$-type layer 44 (outer base). Using the nitride film 47, the CVD-SiO$_2$ film 46 and the n$^+$-type polycrystalline silicon layer 45 as masks, the p$^+$-type impurity was doped by self alignment in silicon substrate 42 and the p-type layer 43. An undoped polycrystalline silicon layer 51 was deposited to a thickness of 4,000 Å (Fig. 4B). Generally, polycrystalline silicon is deposited by the low-pressure CVD (LP-CVD) method or the normal CVD method. The LP-CVD method provides good step coverage. Therefore, the undoped polycrystalline silicon layer can be deposited uniformly in the overhang structure. Part of the undoped polycrystalline silicon layer immediately below the overhang remained as shown in Fig. 4C, when anisotropic etching such as RIE using a CCl$_4$ + O$_2$ etchant was performed. The etching rate of the polycrystalline silicon layer is several tens times that of the thermal oxide film 48b. Therefore, when the undoped polycrystalline silicon layer was completely etched, the thermal oxide film 48b on the p$^+$-type layer 44 remained. The residual thermal oxide film 48b was then etched by ammonium fluoride. An undoped polycrystalline silicon layer 51' which was the self-aligned residual pattern formed by RIE was used as a mask for the thermal oxide film 48a formed on the side surfaces of the n$^+$-type polycrystalline silicon pattern. The thermal oxide film 48a was not substantially etched (Fig. 4D). The nitride film 47 was then removed by the hot concentrated sulfuric acid at 160°C to form an electrode film 52. A high-performance npn bipolar transistor having a double base, elaborate structure was manufactured (Figs. 4E, 5, and 6). Fig. 5 is a plan view of the npn bipolar transistor shown in Fig. 4E and Fig. 6 is a sectional view along the line X—X in Fig. 5. The n$^+$-type layer (collector electrode region) 50 is shown in Fig. 5. Reference numerals 53 and 60 denote an oxide isolation layer and a p$^+$-isolation layer, respectively, in Fig. 6.

According to the above example, the thermal oxide film 48b is selectively etched by an ammonium fluoride etchant, using the undoped polycrystalline silicon layer 51' as a mask. The thermal oxide film 48a surrounded by the undoped polycrystalline silicon layer 51' is not substantially etched and formed in a self-aligned manner. Short-circuiting between the base and the emitter does not occur immediately after sintering is performed at a temperature of 500°C. The damage due to RIE and the heavy metal contamination are substantially eliminated. The current amplification factor hFE in low current range is not degraded. The base contact resistance is not increased. Further, the oxidation induced stacking fault (OSF) is substantially eliminated. Therefore, the distance between the base contact hole and the emitter layer is minimized, and a high performance semiconductor device is obtained. Especially, the metal electrode 52 with a good conductivity is deposited on the base layer 44, so that the base resistance can be decreased, and the common emitter gain band width product fT (transition frequency) is increased.

### Example 5

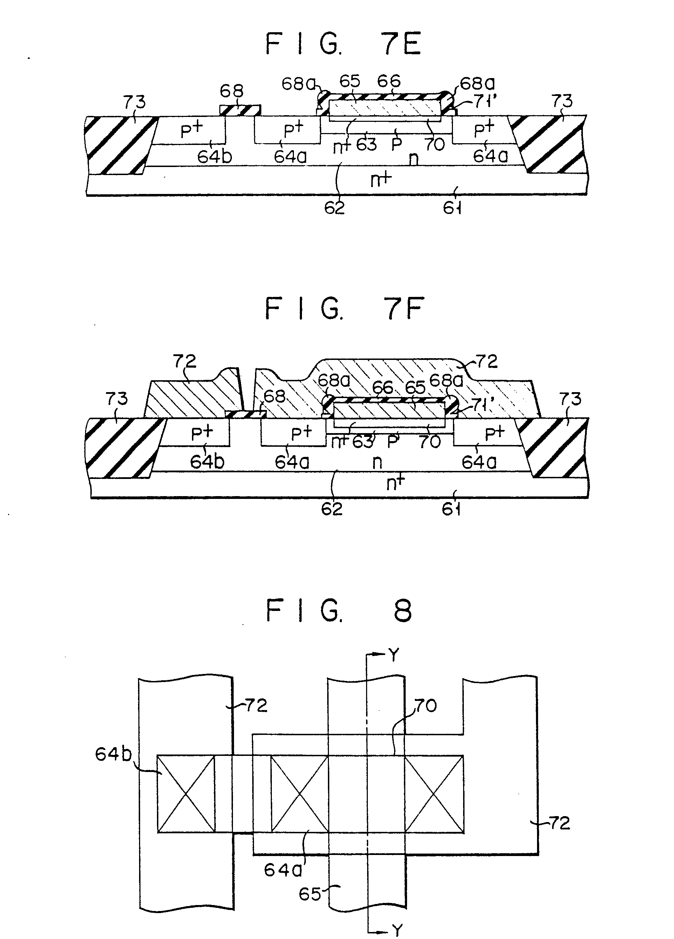

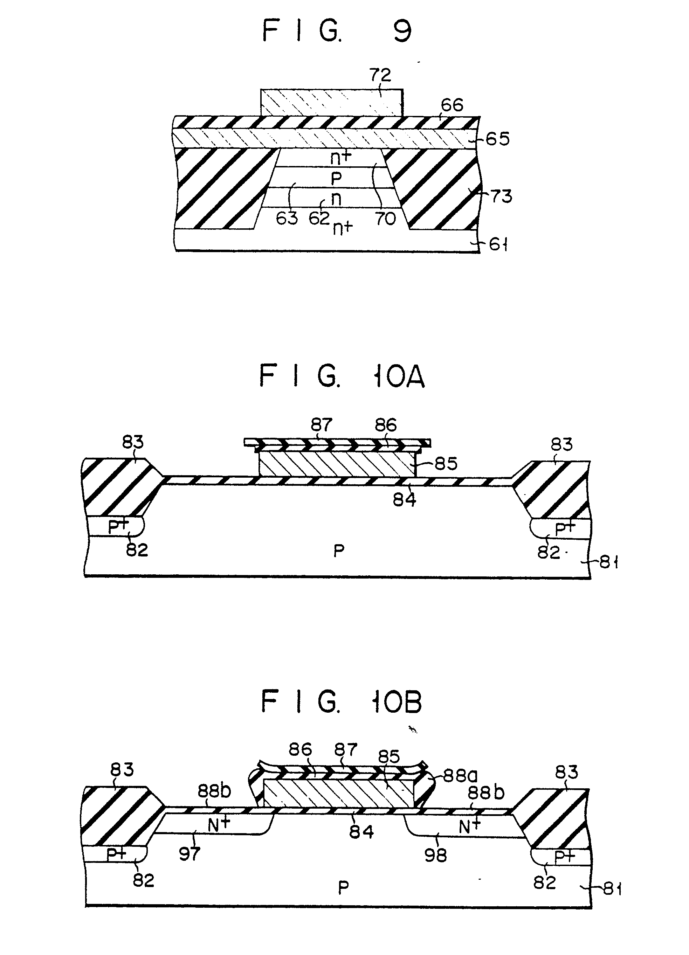

An oxide film collar 73 was formed in an n-type epitaxial layer 62 having an $n^+$-type buried layer 61. The surface layer of the n-type epitaxial layer 62 was oxided to a thickness of 4,000 Å to form an oxide film pattern 68 (Fig. 7A). Boron of a low concentration was then selectively ion-implanted at an acceleration voltage of 200 to 300 keV to form a p-type base layer 63 of an $I^2L$ in the n-type epitaxial layer 62. A polycrystalline silicon layer doped with an $n^+$-type impurity was formed to a thickness of 2,000 Å, and a CVD-SiO$_2$ film 66 was then formed thereon to a thickness of 1,500 Å. A nitride film 67 was formed to a thickness of 3,000 Å. Thereafter, the $n^+$-type polycrystalline silicon layer 65, the CVD-SiO$_2$ layer 66 and the nitride film 67 were selectively etched to form patterns, respectively. The CVD-SiO$_2$ film 66 may be slightly etched (Fig. 7B). Wet oxidation was then performed at a temperature of 900°C to convert the side surface layer of the $n^+$-type polycrystalline silicon pattern 65 to a thermal oxide film 68a of 3,500 Å thickness and the surface layer of the n-type epitaxial layer to a thermal oxide film 68b of 1,000 Å thickness. Upon wet oxidation, the $n^+$-type impurity in the $n^+$-type polycrystalline silicon layer was diffused into the p-type base layer 63 to form an $n^+$-type layer 70 (collector region). Thereafter, ion-implantation was performed to form an injector 64b and an outer base layer 64a ($p^+$-type base layer) in a self-aligned manner. An undoped polycrystalline silicon layer 71 was then deposited to a thickness of 5,000 Å to cover the entire surface (Fig. 7C). RIE was performed to form a residual undoped polycrystalline silicon layer 71' shown in Fig. 7D. The oxide film 68 was etched in a self-aligned manner, using the residual undoped polycrystalline silicon layer as a mask. Thus, the base contact hole was formed (Fig. 7E). Thereafter, the nitride film 67 was etched to form contact holes of the emitter and collector. Metal electrodes 72 were formed to complete an $I^2L$ (Figs. 7F, 8 and 9). Fig. 8 is a plan view of the $I^2L$ shown in Fig. 7F and Fig. 9 is a sectional view along the line Y—Y in Fig. 8.

Alignment margin between the base and the collector need not be required in the $I^2L$ manufactured in the manner described above. Therefore, elaborate patterning of the elements can be performed. The ratio of the junction area between the base and the collector to that between the base and the emitter can be as close as 1. The upward current amplification factor $\beta_{up}$ can be increased and the switching speed of the device is increased. The base layer ($p^+$-type base layer) is connected to the metal electrodes, so that the gates having a large fanout which are apart from the injector are not influenced by the base resistance. Thus, the $I^2L$-LSI of high packing density and high speed can be manufactured.

### Example 6

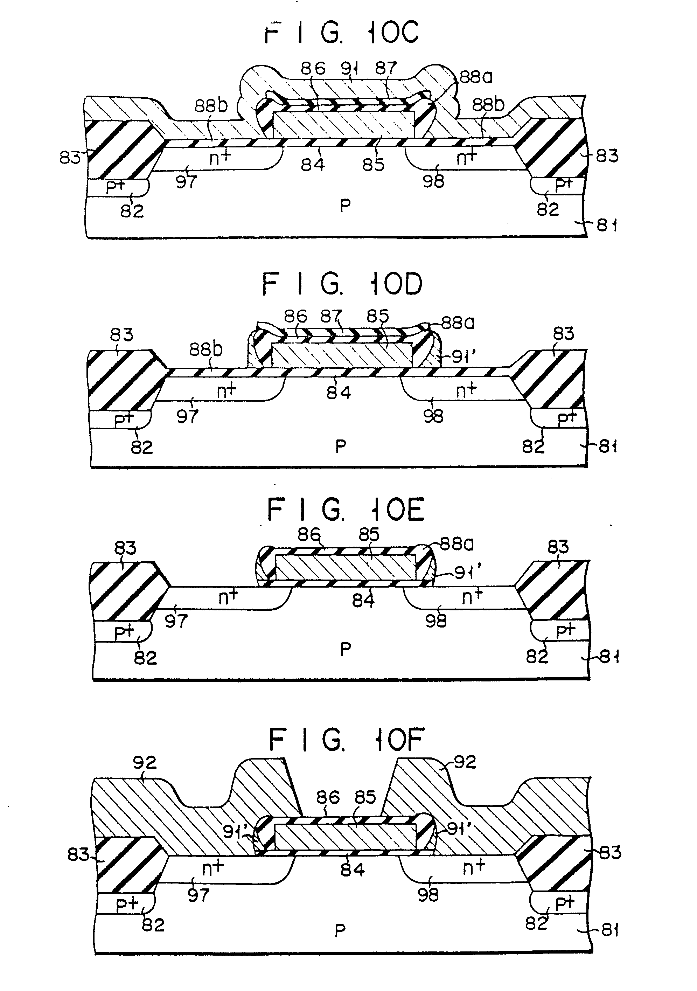

A $p^+$-type layer as a channel stopper was formed in a p-type silicon substrate 81 and an oxide buried layer 83 was formed therein. A gate oxide film 84 was then formed on the silicon substrate 81 to a thickness of about 400 Å. An $n^+$-type impurity doped polycrystalline silicon layer 85 which was defined as the gate electrode was formed to a thickness of 3,000 Å. A CVD-SiO$_2$ film 86 was deposited to a thickness of 1,500 Å, and a nitride film 87 was deposited to a thickness of 1,000 Å. The $n^+$-type polycrystalline silicon layer 85, the CVD-SiO$_2$ film 86, and the nitride film 87 were selectively patterned (Fig. 10A). Parts of the oxide film 84 and the CVD-SiO$_2$ film 86 on which the $n^+$-type polycrystalline silicon pattern 85 was not formed were etched. Therefore, only the nitride film 87 was overhung on the $n^+$-type polycrystalline silicon pattern 85. Wet oxidation was then performed at a temperature of 800°C. An oxide film 88a of 3,000 Å thickness was formed on the side surfaces of the $n^+$-type polycrystalline silicon pattern 85. Further, a very thin oxide film 88b of 500 Å thickness was formed on the p-type silicon substrate 81. Thereafter, arsenic or phosphor of a high concentration was ion-implanted in the p-type silicon substrate through the very thin oxide film 88b and annealing was then performed to form an $n^+$-type layer 97 as the source region and an $n^-$-type layer 98 as the drain region (Fig. 10B). An $n^+$-type polycrystalline silicon pattern which had an overhang structure and which was covered with the oxide film 88a and the nitride film 87 was formed on the p-type silicon substrate. An undoped polycrystalline silicon layer 91 was deposited to cover the entire surface to a thickness of 4,000 Å (Fig. 10C) by the LP (low pressure) CVD method. The undoped polycrystalline silicon layer 91 was uniformly formed even under the overhang portion. It was then etched by RIE. The polycrystalline silicon layer 91' remained to surround the oxide film 88a (Fig. 10D). A gas mixture of CCl$_4$ and O$_2$ was used as the etchant to etch the polycrystalline silicon layer. Since the etching rate of the oxide film was one-tenth of that of the polycrystalline silicon layer, RIE etching stopped at the oxide film 88b. Thus, the heavy metal contamination and the electrical damage due to RIE are eliminated and short-circuiting between the source and the gate or between the drain and the gate is prevented. The wafer was dipped in ammonium fluoride to etch the oxide film 88b (Fig. 10E). Simultaneously, the heavy metal contamination due to RIE was eliminated. Since the thickness of the oxide film 88b was as thin as 500 Å, no problem was presented even if undercutting occurred due to wet etching (isotropic etching). Further, since the oxide film 88a was covered by the undoped polycrystalline silicon layer 91' which was not substantially etched by ammonium fluoride, the oxide film 88a was not etched. Therefore, short-circuiting between the metal source electrode and the metal gate electrode or between the metal drain electrode and the metal gate electrode was completely eliminated. Thus, the self-aligned source and drain contact holes were formed without masking alignment. After metal electrodes 92 were deposited to a thickness of 1 µm, they were isolated from each other to manufacture a MOS type semiconductor device (Fig. 10F).

## Claims

1. A method for manufacturing a semiconductor device, comprising the steps of:

forming a conductive material pattern (6) covered with a first insulating film (5), directly or through an insulating layer (4) on a semiconductor substrate (1);

forming at least a second insulating film (10) at least on the surface of said semiconductor substrate (1) and on the side surfaces of said conductive material pattern (6);

forming a masking material layer (11) of a material which allows selective etching of said second insulating film (10), to cover the entire surface;

etching said masking material layer (11) by anisotropic etching to form a masking material pattern (11') on the surface part of said second insulating layer film (10) formed on the side surfaces of said conductive material pattern (6); and

forming contact holes (12) by etching said second insulating layer (10) formed on the surface of said semiconductor substrate (1) or forming impurity regions by ion-implanting impurities in said semiconductor substrate (1), using said masking material pattern (11') as a mask.

2. A method according to claim 1, wherein said second insulating film (10) is formed to cover the entire surface by the CVD method.

3. A method according to claim 2, wherein said second insulating film (4) comprises an $SiO_2$ film.

4. A method according to claim 1, wherein said second insulating film (51) is formed thinly on the surface of said semiconductor substrate (41) and thickly on the side surfaces of said conductive material pattern (45) by wet oxidation.

5. A method according to claim 2, wherein said first insulating film (5) comprises an $SiO_2$ film.

6. A method according to claim 4, wherein said first insulating film comprises a laminate of an $SiO_2$ film (46) and an $Si_3N_4$ film (47).

7. A method according to claim 1, wherein said conductive material pattern (6) comprises a material selected from the group consisting of impurity-doped polycrystalline silicon, impurity-doped amorphous silicon, a refractory metal, a metal silicide, Al and an Al alloy.

8. A method according to claim 1, wherein said masking material layer (11) comprises a material selected from the group consisting of undoped polycrystalline silicon, a metal silicide, silicon nitride, and an organic material.

9. A method according to claim 1, wherein the anisotropic etching is reactive ion etching.

## Patentansprüche

1. Verfahren zur Herstellung einer Halbleitervorrichtung, umfassend die Schritte:

Ausbilden eines mit einem ersten Isolierfilm (5) bedeckten Musters (6) aus einem leitenden Material direkt oder über eine Isolierschicht (4) auf einem Halbleitersubstrat (1),

Ausbilden wenigstens eines zweiten Isolierfilms (10) wenigstens auf der Oberfläche des Halbleitersubstrats (1) und den Sietenflächen des Musters (6) aus leitendem Material,

Ausbilden einer Maskenmaterialschicht (11) zur Bedeckung der gesamten Oberfläche aus einem Material, das ein selektives Ätzen des zweiten Isolierfilms (10) erlaubt,

Ätzen der Maskenmaterialschicht (11) mittels anisotropen Ätzens zum Ausbilden eines Maskenmaterialmusters (11') auf dem Oberflächenteil des zweiten Isolierschichtfilms (10), der an den Seitenflächen des Musters (6) aus leitendem Material ausgebildet ist, und

Ausbilden von Kontaktlöchern (12) durch Ätzen der zweiten Isolierschicht (10), die auf der Oberfläche des Halbleitersubstrats (1) ausgebildet ist, oder Ausbilden von Störstellenzonen durch Ionenimplantieren von Störstellen in das Halbleitersubstrat (1) unter Verwendung des Maskenmaterialmusters (11') als Maske.

2. Verfahren nach Anspruch 1, bei dem der zweite Isolierfilm (10) mittels des CVD-Verfahrens so ausgebildet wird, daß er die gesamte Oberfläche bedeckt.

3. Verfahren nach Anspruch 2, bei dem der zweite Isolierfilm (4) einen $SiO_2$-Film umfaßt.

4. Verfahren nach Anspruch 1, bei dem der zweite Isolierfilm (51) durch Naßoxidation auf der Oberfläche des Halbleitersubstrats (41) dünn und auf den Seitenflächen des Musters (45) aus leitendem Material dick ausgebildet wird.

5. Verfahren nach Anspruch 2, bei dem der erste Isolierfilm (5) einen $SiO_2$-Film umfaßt.

6. Verfahren nach Anspruch 4, bei dem der erste Isolierfilm ein Laminat aus einem $SiO_2$-Film (46) und einem $Si_3N_4$-Film (47) umfaßt.

7. Verfahren nach Anspruch 1, bei dem das Muster (6) aus leitendem Material ein Material umfaßt, ausgewählt aus der Gruppe enthaltend mit Störstellen dotiertes polykristallines Silicium, mit Störstellen dotiertes amorphes Silicium, ein feuerfestes Metall, eine Metall-Silicium-Verbindung, Al und eine Al-Legierung.

8. Verfahren nach Anspruch 1, bei dem die Maskenmaterialschicht (11) ein Material umfaßt, ausgewählt aus der Gruppe enthaltend undotiertes polykristallines Silicium, eine Metall-Silicium-Verbindung, Siliciumnitrid, und ein organisches Material.

9. Verfahren nach Anspruch 1, bei dem das anisotrope Ätzen ein reaktives Ionenätzen ist.

## Revendications

1. Une méthode de fabrication d'un dispositif à semiconducteur comprenant les étapes suivantes:

formation d'un dessin de matériau conducteur (6) couvert par un premier film isolant (5), directement ou par l'intermédiaire d'une couche isolante (4) sur un substrat semiconducteur (1);

formation d'au moins un second film isolant (10) au moins sur la surface dudit substrat semiconducteur (1) et sur les surfaces latérales dudit dessin de matériau conducteur (6);

formation d'une couche de matériau de masquage (11) en un matériau qui permet la gravure sélective dudit second film isolant (10), pour couvrir la surface entière;

gravure de ladite couche de matériau de masquage (11) par gravure anisotropique pour former un dessin de matériau de masquage (11') sur la partie de surface dudit second film de couche isolante (10) formée sur les surfaces latérales dudit dessin de matériau conducteur (6); et

formation des trous de contact (12) par gravure de ladite seconde couche isolante (10) formée sur la surface dudit substrat semiconducteur (1) ou formation de régions d'impuretés par implantation ionique d'impuretés dans ledit substrat semiconducteur (1), utilisant le dessin de matériau de masquage (11') comme un masque.

2. Une méthode selon la revendication 1, dans laquelle ledit second film isolant (10) est formé pour couvrir la surface entière par la méthode CVD (dépôt chimique en phase vapeur).

3. Une méthode selon la revendication 2, dans laquelle ledit second film isolant (4) comprend un film de SiO$_2$.

4. Une méthode selon la revendication 1, dans laquelle ledit second film isolant (51) est formé avec une faible épaisseur sur la surface dudit substrat semiconducteur (41) et avec une grande épaisseur sur les surfaces latérales dudit dessin de matériau conducteur (45) par oxydation par voie humide.

5. Une méthode selon la revendication 2, dans laquelle ledit premier film isolant (5) comprend un film de SiO$_2$.

6. Une méthode selon la revendication 1, dans laquelle ledit premier film isolant comprend un stratifié d'un film de SiO$_2$ (46) et d'un film de Si$_3$N$_4$ (47).

7. Une méthode selon la revendication 1, dans laquelle ledit dessin de matériau conducteur (6) comprend un matériau choisi dans le groupe comprenant le silicium polycristallin dopé par une impureté, le silicium amorphe dopé par une impureté, un métal réfractaire, un siliciure de métal. Al et un alliage de Al.

8. Une méthode selon la revendication 1, dans laquelle ladite couche de matériau de masquage (11) comprend un matériau choisi dans le groupe comprenant le silicium polycristallin non dopé, un siliciure de métal, le nitrure de silicium et un matériau organique.

9. Une méthode selon la revendication 1, dans laquelle la gravure anisotropique est une gravure par ion réactif.

F I G. 1A

F I G. 1B

F I G. 1C

F I G. 1D

F I G. 1E

F I G. 1F

F I G. 2A

## F I G.  2B

## F I G.  2C

## F I G.  3A

## F I G.  3B

0 066 280

## F I G. 3C

## F I G. 3D

## F I G. 3E

# F I G. 4A

# F I G. 4B

# F I G. 4C

# F I G. 4D

5

# F I G. 4E

# F I G. 5

# F I G. 6

FIG. 7A

FIG. 7B

FIG. 7C

FIG. 7D

# F I G.  7E

# F I G.  7F

# F I G.  8

## F I G. 9

## F I G. 10A

## F I G. 10B

## F I G. 10C

## F I G. 10D

## F I G. 10E

## F I G. 10F

10